(19) Europäisches Patentamt
European Patent Office
Office européen des brevets

(11) **EP 3 503 165 B1**

(12) **FASCICULE DE BREVET EUROPEEN**

(45) Date de publication et mention
de la délivrance du brevet:
**03.03.2021 Bulletin 2021/09**

(51) Int Cl.:
***H01L 21/027*** (2006.01)     ***B81C 1/00*** (2006.01)

(21) Numéro de dépôt: **18214862.7**

(22) Date de dépôt: **20.12.2018**

(54) **PROCÉDÉ DE FORMATION D'UNE STRUCTURE DE GUIDAGE CHIMIQUE SUR UN SUBSTRAT ET PROCÉDÉ DE CHÉMO-ÉPITAXIE**

VERFAHREN ZUR BILDUNG EINER CHEMISCHEN LEITSTRUKTUR AUF EINEM SUBSTRAT, UND CHEMO-EPITAXIE-VERFAHREN

METHOD FOR FORMING A CHEMICAL GUIDING STRUCTURE ON A SUBSTRATE AND METHOD FOR CHEMO-EPITAXY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **21.12.2017 FR 1762863**

(43) Date de publication de la demande:
**26.06.2019 Bulletin 2019/26**

(73) Titulaire: **Commissariat à l'Energie Atomique et aux Energies Alternatives**
**75015 Paris (FR)**

(72) Inventeurs:
• **TIRON, Raluca**
**38950 SAINT-MARTIN-LE-VINOUX (FR)**
• **CLAVEAU, Guillaume**
**79230 SAINT MARTIN DE BERNEGOUE (FR)**
• **GHARBI, Ahmed**
**38000 GRENOBLE (FR)**
• **PAIN, Laurent**
**38500 SAINT NICOLAS DE MACHERIN (FR)**

• **CHEVALIER, Xavier**
**38100 GRENOBLE (FR)**
• **NAVARRO, Christophe**
**64100 BAYONNE (FR)**
• **PAQUET, Anne**
**74940 ANNECY-LE-VIEUX (FR)**

(74) Mandataire: **Cabinet Camus Lebkiri**
**25 rue de Maubeuge**
**75009 Paris (FR)**

(56) Documents cités:
**US-A1- 2017 069 486**

• **LIU CHI-CHUN ET AL: "Integration of block copolymer directed assembly with 193 immersion lithography", JOURNAL OF VACUUM SCIENCE AND TECHNOLOGY: PART B, AVS / AIP, MELVILLE, NEW YORK, NY, US, vol. 28, no. 6, 30 novembre 2010 (2010-11-30), pages C6B30-C6B34, XP012144322, ISSN: 1071-1023, DOI: 10.1116/1.3501348**

## Description

## DOMAINE TECHNIQUE

La présente invention concerne un procédé de formation d'une structure de guidage chimique destinée à l'auto-assemblage d'un copolymère à blocs par chémo-épitaxie. La présente invention concerne également un procédé de chémo-épitaxie à partir d'une structure de guidage chimique.

## ÉTAT DE LA TECHNIQUE

L'auto-assemblage dirigé de copolymères à blocs (DSA, pour « Directed Self-Assembly » en anglais) est une technique de lithographie émergente permettant de former des motifs de dimension critique inférieure à 30 nm. Cette technique constitue une alternative moins onéreuse à la lithographie extrême ultraviolet (EUV) et à la lithographie par faisceau d'électrons (« e-beam »).

Les procédés connus d'auto-assemblage de copolymères à blocs peuvent être regroupés en deux catégories : la grapho-épitaxie et la chémo-épitaxie.

La grapho-épitaxie consiste à former des motifs topographiques primaires appelés guides à la surface d'un substrat, ces motifs délimitant des zones à l'intérieur desquelles une couche de copolymère à blocs est déposée. Les motifs de guidage permettent de contrôler l'organisation des blocs de copolymère pour former des motifs secondaires de plus haute résolution à l'intérieur de ces zones.

La chémo-épitaxie consiste à modifier les propriétés chimiques de certaines régions de la surface du substrat, pour guider l'organisation du copolymère à blocs déposé ultérieurement sur cette surface. La modification chimique du substrat peut notamment être obtenue par le greffage d'une couche de neutralisation en polymère. Puis, cette couche de neutralisation est structurée afin de créer un contraste chimique à la surface du substrat. Ainsi, les régions du substrat non recouvertes par la couche de neutralisation ont une affinité chimique préférentielle pour l'un des blocs du copolymère, tandis que les régions du substrat recouvertes par la couche de neutralisation ont une affinité chimique équivalente pour tous les blocs du copolymère. La structuration de la couche de neutralisation est classiquement obtenue par une étape de lithographie optique ou à faisceau d'électrons.

Pour garantir un assemblage du copolymère à blocs avec un minimum de défauts d'organisation, les régions du substrat ayant une affinité préférentielle pour l'un des blocs sont typiquement de largeur W égale à la largeur du domaine de copolymère à blocs, cette dernière étant égale à la moitié de la période naturelle $L_0$ du copolymère (W = $0{,}5*L_0$) ou égale à une fois et demie cette période naturelle (W = $1{,}5*L_0$). En outre, les régions du substrat ayant une affinité préférentielle sont typiquement séparées deux à deux d'une distance $L_s$ égale à un multiple entier de la période $L_0$ (Ls = $n*L_0$, avec *n* un entier naturel non nul appelé facteur de multiplication du pas).

L'article de C-C. Liu et al. intitulé [« Intégration of block copolymer directed assembly with 193 immersion lithography », J. Vac. Sci. Technol., B 28, C6B30-C6B34, 2010] décrit un procédé de chémo-épitaxie comprenant la formation d'une structure de guidage chimique à la surface d'un substrat. La structure de guidage chimique est composée de motifs de guidage en un polymère ayant une affinité préférentielle pour l'un des blocs du copolymère et d'un film de copolymère statistique greffé sur le substrat en dehors des motifs, dans une région dite d'arrière-plan. Le copolymère statistique est neutre vis-à-vis du copolymère à blocs, de sorte que les domaines du copolymère soient (après assemblage) orientés perpendiculairement au substrat. La structure de guidage chimique est destiné à diriger l'auto-assemblage du copolymère à blocs PS-*b*-PMMA (polystyrène-*bloc*-polyméthylméthacrylate). Les motifs de guidage, en forme de lignes, sont constitués de polystyrène réticulé (X-PS). Le copolymère statistique, greffé entre les lignes, est le PS-*r*-PMMA.

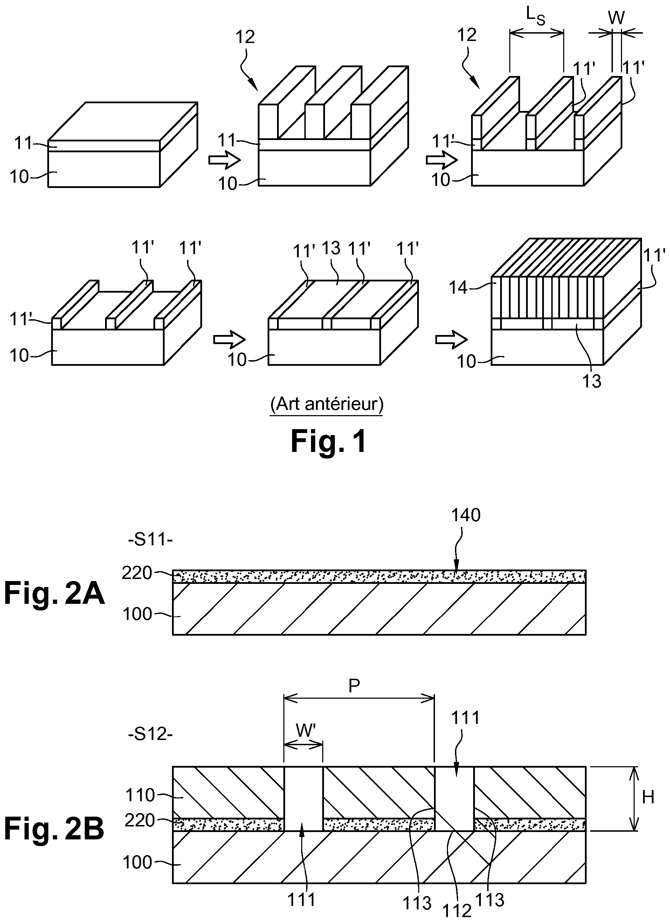

En référence à la figure 1, ce procédé de chémo-épitaxie comprend tout d'abord la formation d'un film de polystyrène réticulé 11 sur un substrat en silicium 10. Un masque constitué de motifs en résine 12 est ensuite formé sur le film de polystyrène réticulé 11, par lithographie optique (typiquement en 193 nm immersion). Puis, les dimensions des motifs de résine 12 sont réduites par une étape de plasma à base d'oxygène afin d'obtenir une largeur W de l'ordre de la demi-période du copolymère à blocs. Lors de cette étape, le film de polystyrène réticulé 11 est également gravé à travers le masque 12 par le plasma. Cette étape de gravure est communément appelée « trim etch ». Des motifs de polystyrène réticulé, en forme de lignes 11' parallèles, sont ainsi formés sur le substrat 10. Après l'étape de gravure «trim etch », les lignes de polystyrène 11' ont une largeur W égale à 15 nm et sont espacées deux à deux d'une distance $L_s$ égale à 90 nm. Après retrait du masque 12 en résine, le substrat 10 est recouvert d'une solution comprenant le copolymère statistique greffable, puis le copolymère statistique est greffé entre les lignes 11' pour former une couche de neutralisation 13. Enfin, une couche de PS-b-PMMA 14 est déposée puis assemblée sur la structure de guidage composée des lignes de polystyrène 11' et de la couche de neutralisation 13.

Ce procédé de chémo-épitaxie donne de bons résultats en ce qui concerne l'assemblage du copolymère à blocs PS-b-PMMA, avec notamment un faible taux de défauts. Il n'est cependant pas compatible avec les copolymères à blocs de nouvelle génération, dits « high-X », ayant une période naturelle $L_0$ inférieure à celle du PS-b-PMMA, car ces derniers requièrent des motifs de guidage de dimension critique très faible, typiquement inférieure à 12,5 nm. La combinaison d'une étape de lithographie optique (typiquement en 193 nm immersion) et d'une étape de gravure additionnelle « trim etch » ne permet pas de créer, de façon reproductible à l'échelle du substrat, des motifs de guidage de dimension critique aussi faible, notamment lorsqu'ils sont en densité élevée. Une forte variabilité est en effet observée dans les dimensions des motifs de guidage et celle-ci se répercute sur l'assemblage du copolymère à blocs, causant un nombre important de défauts. Une solution possible serait la lithographie par extrême ultraviolet (EUV) mais le manque de maturité technologique de cette technique et son coût très élevé la rendent difficilement applicable

Un autre procédé assez similaire est décrit dans le document US 2017 069486, qui utilise un traitement chimique d'un masque de résine ("trimming") pour, finalement, parvenir à réduire la taille de motifs de guidage à moins de 12.5 nm.

## RÉSUMÉ DE L'INVENTION

Il existe donc un besoin de prévoir un procédé de formation d'une structure de guidage chimique sur un substrat, qui soit compatible avec les copolymères à blocs de nouvelle génération et permette un bon contrôle dimensionnel des motifs de guidage, quelle que soit leur répartition sur le substrat.

Selon l'invention, on tend à satisfaire ce besoin en prévoyant un procédé de formation d'une structure de guidage chimique destinée à l'auto-assemblage d'un copolymère à blocs par chémo-épitaxie, ce procédé comprenant les étapes suivantes :

- former sur un substrat une couche de fonctionnalisation en un premier matériau polymère ayant une première affinité chimique vis-à-vis du copolymère à blocs ;
- former sur le substrat des motifs de guidage en un deuxième matériau polymère ayant une deuxième affinité chimique vis-à-vis du copolymère à blocs, différente de la première affinité chimique ;

et dans lequel les motifs de guidage ont une dimension critique inférieure à 12,5 nm et sont formés au moyen d'un masque comprenant des espaceurs.

Grâce aux espaceurs, il est possible d'atteindre des dimensions critiques compatibles avec les copolymères à blocs de nouvelle génération appelés « high-X ». L'utilisation d'espaceurs garantit également une bonne maîtrise du dimensionnement des motifs de guidage, et ce quelle que soit leur répartition sur le substrat. En particulier, les motifs de guidage formés au moyen des espaceurs ont une rugosité de bord de ligne (« Line Edge Roughness » en anglais) et une rugosité de largeur de ligne (« Width Edge Roughness ») plus faibles que dans l'art antérieur, ce qui permet d'obtenir un assemblage du copolymère de meilleure qualité et donc, à terme, de meilleures performances électriques.

Ces avantages proviennent du fait que les espaceurs bénéficient eux-mêmes d'excellentes performances en termes de reproductibilité, de par la manière dont ils sont formés. La formation des espaceurs comprend avantageusement une étape de dépôt conforme d'une couche en matériau sacrificiel sur un motif topographique (i.e. motif en creux ou en saillie) et une étape de gravure anisotrope de la couche en matériau sacrificiel selon une direction préférentielle de gravure perpendiculaire au substrat.

De préférence, la première affinité chimique est équivalente pour chacun des blocs du copolymère et la deuxième affinité chimique est préférentielle pour l'un des blocs du copolymère.

Dans un premier mode de mise en œuvre de l'invention, le procédé de formation comprend les étapes suivantes :

- former la couche de fonctionnalisation sur le substrat ;
- déposer une couche de matériau sacrificiel sur la couche de fonctionnalisation ;
- former dans la couche de matériau sacrificiel et dans la couche de fonctionnalisation des cavités débouchant sur le substrat, chaque cavité comprenant un fond et des parois latérales ;
- former les espaceurs contre les parois latérales des cavités ;
- greffer le deuxième matériau polymère au fond des cavités entre les espaceurs ;
- retirer les espaceurs et la couche de matériau sacrificiel.

Dans un deuxième mode de mise en œuvre de l'invention, le procédé de formation comprend les étapes suivantes :

- former une couche du deuxième matériau polymère sur le substrat ;
- former les espaceurs sur la couche du deuxième matériau polymère ;
- graver la couche du deuxième matériau polymère à travers les espaceurs pour former les motifs de guidage ;
- greffer le premier matériau polymère sur le substrat en dehors des motifs de guidage pour former la couche de fonctionnalisation ; et

- retirer les espaceurs.

Selon un développement du deuxième mode de mise en œuvre, le procédé comprend en outre une étape de modification de la première affinité chimique dans une partie seulement de la couche de fonctionnalisation par exposition à un rayonnement ultraviolet (UV).

De préférence, l'exposition au rayonnement UV est effectuée sur toute la surface du substrat avant l'étape de retrait des espaceurs, le rayonnement UV présente une longueur d'onde comprise entre 150 nm et 350 nm, et les espaceurs sont séparés deux à deux d'une distance inférieure ou égale à la moitié de la longueur d'onde.

Selon un autre développement du deuxième mode de mise en œuvre, le masque comporte au moins deux espaceurs de dimension critique sensiblement égale à la moitié de la période naturelle du copolymère à blocs. Les espaceurs sont en outre espacés deux à deux et centre à centre d'une distance sensiblement égale à un multiple entier de la période naturelle du copolymère à blocs.

Avantageusement, la dimension critique des motifs de guidage est en outre sensiblement égale à la moitié de la période naturelle du copolymère à blocs.

L'invention concerne également un procédé de chémo-épitaxie comprenant la formation d'une structure de guidage chimique sur un substrat à l'aide du procédé de formation décrit ci-dessus, le dépôt d'un copolymère à blocs sur la structure de guidage chimique et l'assemblage du copolymère à blocs.

Le copolymère à blocs est avantageusement un copolymère de période naturelle inférieure à 25 nm, de préférence choisi parmi les suivants :

- PS-*b*-PMMA : polystyrène-bloc-polyméthylméthacrylate, dont au moins un des deux blocs est modifié chimiquement ;
- PS-*b*-PDMS : polystyrène-bloc-polydiméthylsiloxane ;
- PS-*b*-PLA : polystyrène-bloc-acide polylactique ;
- PS-*b*-PEO : polystyrène-bloc-polyoxyde d'éthylène ;
- PS-*b*-PMMA-*b*-PEO : polystyrène-bloc-polyméthylméthacrylate-bloc-polyoxyde d'éthylène ;
- PS-*b*-P2VP : polystyrène-bloc-poly(2vinylpyridine) ;
- PS-*b*-P4VP : polystyrène-bloc-poly(4vinylpyridine) ;
- PS-*b*-PFS : poly(styrene)-block-poly(ferrocenyldimethylsilane) ;
- PS-*b*-PI-*b*-PFS : poly(styrene)-block-poly(isoprene)-block-poly(ferrocenyldimethylsilane) ;
- PS-*b*-P(DMS-r-VMS) : polystyrene-block-poly(dimethylsiloxane-r-vinylmethylsiloxane) ;
- PS-*b*-PMAPOSS : polystyrene-block-poly(methyl acrylate)POSS ;
- PDMSB-*b*-PS : poly(1,1-dimethylsilacyclobutane)-block-polystyrene ;
- PDMSB-*b*-PMMA : poly(1,1-dimethylsilacyclobutane)-block-poly(methyl methacrylate) ;
- PMMA-*b*-PMAPOSS : poly(methyl methacrylate)-block-poly(methyl acrylate)POSS ;
- P2VP-*b*-PDMS : poly(2-vinylpyridine)-block-poly(dimethyl siloxane) ;
- PTMSS-*b*-PLA : poly(trimethylsilylstyrene)-block-poly(D,L-lactide) ;
- PTMSS-*b*-PDLA : poly(trimethylsilylstyrene)-block-poly(D-lactic acid) ;
- PTMSS-*b*-PMOST : poly(trimethylsilylstyrene)-block-poly(4-methoxystyrene) ;
- PLA-*b*-PDMS : poly(D,L-lactide)-block-poly(dimethylsiloxane) ;
- PAcOSt-*b*-PSi2St : poly(4-acetoxystyrene)-block-poly(4-(Bis(trimethylsilyl)methyl)styrene) ;
- 1,2-PB-b-PDMS : 1,2-polybutadiene-block-poly(dimethyl siloxane) ;
- PtBS-*b*-PMMA : poly(4-tert-butylstyrene)-block-poly(methyl methacrylate) ;
- PCHE-*b*-PMMA : polycyclohexane-block-poly(methyl methacrylate) ;
- MH-*b*-PS : maltoheptaose-block-polystyrene.

**BRÈVE DESCRIPTION DES FIGURES**

D'autres caractéristiques et avantages de l'invention ressortiront clairement de la description qui en est donnée ci-dessous, à titre indicatif et nullement limitatif, en référence aux figures annexées, parmi lesquelles :

- la figure 1, précédemment décrite, représente des étapes d'un procédé de chémo-épitaxie selon l'art antérieur ;
- les figures 2A à 2F représentent des étapes d'un procédé pour former une structure de guidage chimique, selon un premier mode de mise en œuvre de l'invention ;
- la figure 3 représente l'assemblage d'un copolymère à blocs déposé sur la structure de guidage chimique de la figure 2F ;
- les figures 4A à 4G représentent des étapes d'un procédé pour former une structure de guidage chimique, selon un deuxième mode de mise en œuvre de l'invention ;

- la figure 5 représente l'assemblage d'un copolymère à blocs déposé sur la structure de guidage chimique de la figure 4G ;
- la figure 6 représente une étape additionnelle facultative du procédé des figures 4A-4G ; et
- la figure 7 représente l'assemblage d'un copolymère à blocs sur la structure de guidage chimique obtenue après l'étape de la figure 6.

Pour plus de clarté, les éléments identiques ou similaires sont repérés par des signes de référence identiques sur l'ensemble des figures.

## DESCRIPTION DÉTAILLÉE D'AU MOINS UN MODE DE RÉALISATION

Le procédé décrit ci-après en relation avec les figures 2A-2F, 4A-4G et 6 permet de former une structure de guidage chimique sur une face d'un substrat 100. Une structure de guidage chimique désigne ici un ensemble d'au moins deux motifs de polymère disposés sur des régions distinctes du substrat 100 et présentant des affinités chimiques différentes, cet ensemble étant répété périodiquement à la surface du substrat. Un contraste chimique est ainsi créé à la surface du substrat. Le substrat 100 est par exemple en silicium. Le substrat 100 peut présenter une affinité chimique identique à l'un des deux motifs de polymère.

Cette structure de guidage (ou de contraste) chimique est destinée à être recouvert d'un copolymère à blocs, dans le cadre d'un procédé d'auto-assemblage dirigé de copolymère à blocs par chémo-épitaxie. Le contraste chimique permet de diriger (ou « guider ») l'organisation des blocs de monomère qui composent le copolymère. Ainsi, les affinités chimiques des motifs de polymère s'entendent par rapport aux blocs du copolymère. Ces affinités peuvent être choisies parmi les possibilités suivantes :

- affinité préférentielle pour l'un quelconque des blocs du copolymère ; ou
- neutre, c'est-à-dire avec une affinité équivalente pour chacun des blocs du copolymère.

Une faible différence d'épaisseur, typiquement inférieur à 10 nm, peux exister entre les motifs de la structure de guidage chimique ou entre le substrat et les motifs. Cette différence d'épaisseur, formant un contraste topographique, n'a toutefois pas d'impact négatif sur l'assemblage du copolymère à blocs.

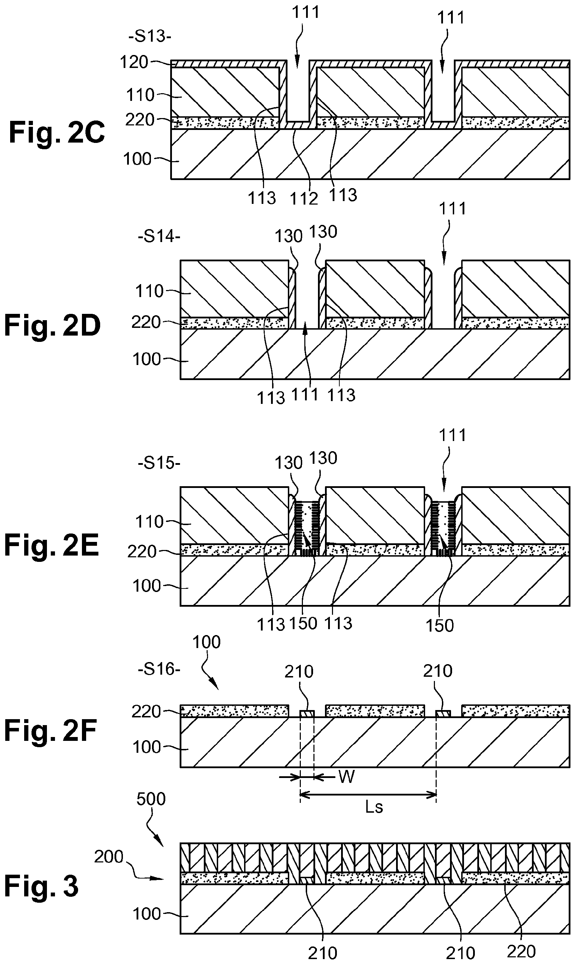

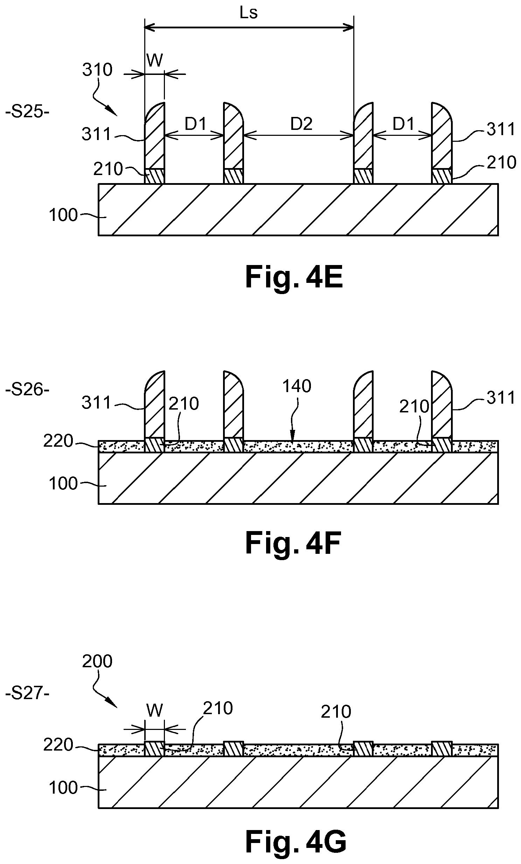

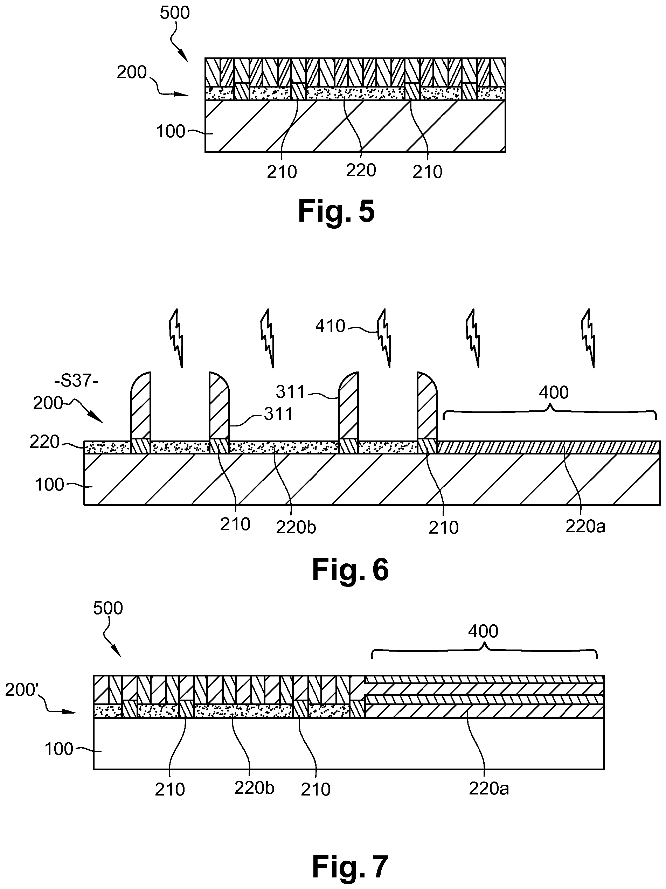

En référence aux figures 2F, 4G et 6, la structure de guidage 200 comporte de préférence plusieurs motifs de guidage 210 et une couche de neutralisation 220. La couche de neutralisation 220 occupe au moins une région de la surface du substrat 100 dépourvue de motifs de guidage 210, et dans certains modes de mise en œuvre du procédé, toute la surface du substrat 100 en dehors des motifs de guidage 210 (cf. Figs.4G & 6).

Les motifs de guidage 210 et la couche de neutralisation 220 ont pour rôle de fonctionnaliser chimiquement (et différemment) le substrat 100. Ils pourront donc également être qualifiés de motifs et couche de fonctionnalisation. Les motifs de guidage 210 sont formés d'un polymère ayant une affinité préférentielle pour l'un des blocs du copolymère, tandis que la couche de neutralisation 220 est constituée d'un polymère dont l'affinité est neutre. Les motifs de guidage 210 ont de préférence une dimension critique W sensiblement égale à la moitié de la période naturelle $L_0$ du copolymère à blocs (W = $L_0$/2 $\pm$ 10 %).

Dans la description qui suit, on entend par « greffage » d'un polymère sur un substrat la formation de liaisons covalentes entre le substrat et les chaînes du polymère. À titre de comparaison, la réticulation d'un polymère implique la formation de plusieurs liaisons entre les chaînes du polymère.

Les figures 2A à 2F sont des vues de coupe illustrant des étapes S11 à S16 du procédé de formation de structure de guidage chimique, selon un premier mode de mise en œuvre de l'invention.

La première étape S11 du procédé, illustrée par la figure 2A, consiste à former la couche de neutralisation 220 à la surface du substrat 100. De préférence, la couche de neutralisation 220 présente une épaisseur sensiblement constante, par exemple comprise entre 2 nm et 15 nm, et occupe toute la surface du substrat 100. La couche de neutralisation 220 est constituée d'un premier polymère 140 dont l'affinité est neutre. Ce premier polymère 140 est de préférence un copolymère statistique composé des mêmes monomères que le copolymère à blocs envisagé pour le procédé de chémo-épitaxie. Par exemple, lorsque le copolymère à blocs est le PS-b-PMMA (dont au moins un des blocs a été modifié) de morphologie lamellaire, la couche de neutralisation 220 peut être formée du copolymère statistique PS-r-PMMA (avec le même bloc modifié), comportant par exemple 50% en masse de polystyrène (PS) et 50 % en masse de polyméthacrylate de méthyle (PMMA). La couche de neutralisation 220 peut également être une monocouche auto-assemblée (également appelée SAM pour « Self-Assembled Monolayer »).

Le premier polymère 140 de la couche de neutralisation 220 est avantageusement un matériau greffable. L'étape S11 de formation de la couche de neutralisation 220 comporte alors le dépôt sur le substrat 100 d'une première solution contenant le premier polymère greffable, de préférence par centrifugation (également appelé « spin-coating » en anglais). La première solution est préparée en diluant le premier polymère 140 dans un solvant organique, par exemple de l'acétate de l'éther monométhylique du propylène glycol (également appelé PGMEA pour « Propylene glycol methyl ether acetate »). Le dépôt de la première solution est suivi d'une opération de greffage du premier polymère 140 sur le substrat 100, de préférence par recuit. Le recuit est par exemple effectué à une température égale à 250°C, pendant une durée égale à 10 minutes, sur une plaque chauffante ou dans un four. Une opération de rinçage à l'aide d'un solvant (ex. PGMEA) permet ensuite d'éliminer le premier polymère 140 qui n'a pas été greffé.

Alternativement, le premier polymère 140 peut être un matériau réticulable. Après étalement de la première solution par centrifugation, le premier polymère 140 est réticulé par recuit ou par exposition à des rayons UV. Comme l'opération de greffage, l'opération de réticulation est avantageusement suivie d'un rinçage au moyen d'un solvant.

L'étape S12 de la figure 2B comprend le dépôt d'une première couche 110 en matériau sacrificiel sur la couche de neutralisation 220 et la formation de cavités 111 dans la première couche 110 et la couche de neutralisation 220. Par souci de clarté, seulement deux de ces cavités 111 ont été représentées sur la figure 2B.

Chaque cavité 111 possède un fond 112 et des parois latérales 113 s'étendant suivant une direction sécante à la surface du substrat 100. De préférence, les parois latérales 113 s'étendent suivant une direction perpendiculaire à la surface du substrat 100. Par ailleurs, chaque cavité 111 débouche sur la surface du substrat 100. Autrement dit, le fond 112 de la cavité 111 est constitué par le substrat 100, dont la surface est avantageusement plane.

Chaque cavité 111 présente de préférence une profondeur H comprise entre 30 nm et 150 nm et une largeur W' comprise entre 30 nm et 60 nm. La profondeur H d'une cavité est mesurée perpendiculairement à la surface du substrat 100, tandis que la largeur W' de la cavité est mesurée parallèlement à la surface du substrat 100 dans le plan de coupe de la figure 2B.

Lorsque la première couche 110 comporte plusieurs cavités 111, celles-ci n'ont pas nécessairement les mêmes dimensions, ni la même géométrie. Les cavités 111 peuvent notamment prendre la forme d'une tranchée, d'un puits cylindrique ou d'un puits de section rectangulaire.

À titre d'exemple, les cavités 111 sont des tranchées rectilignes, de dimensions identiques et orientées parallèlement les unes aux autres. Elles forment en outre une structure périodique, c'est-à-dire qu'elles sont espacées régulièrement. La période P de cette structure est de préférence comprise entre 60 nm et 140 nm.

Le matériau sacrificiel de la première couche 110 est de préférence choisi parmi les matériaux qui peuvent être aisément retirés par gravure humide et/ou par gravure sèche, de façon sélective par rapport au substrat 100. À titre d'exemple, on peut citer le dioxyde de silicium ($SiO_2$), l'hydrogène silsesquioxane (HSQ) et le nitrure de silicium ($Si_3N_4$). Alternativement, la première couche 110 en matériau sacrificiel peut être formée d'un revêtement antireflet contenant du silicium (appelé également « SiARC », pour « Silicon-containing Anti-Reflective Coating » en anglais).

Les cavités 111 peuvent être formées par photolithographie ou d'autres techniques de structuration, comme la lithographie à faisceau d'électrons (« e-beam »). Dans le cas de la photolithographie, par exemple à une longueur d'onde de 193 nm en immersion, la formation des cavités 111 peut notamment comporter les opérations suivantes :

- dépôt sur la première couche 110 d'une couche de résine ou de plusieurs couches destinées à former un masque dur, par exemple un empilement de trois couches comprenant successivement une couche carbonée déposée par centrifugation (« Spin On Carbon », SOC), un revêtement antireflet contenant du silicium (SiARC) et une couche de résine ;

- réalisation d'ouvertures dans la couche de résine et, le cas échéant, transfert des ouvertures dans les couches sous-jacentes du masque dur (étape d'ouverture du masque) ; et

- gravure sélective de la première couche 110 et de la couche de neutralisation 220 à travers le masque en résine ou le masque dur, le substrat 100 étant insensible à la gravure ou protégé par une couche insensible à la gravure.

La première couche 110 et de la couche de neutralisation 220 sont avantageusement gravées de façon anisotrope, par exemple au moyen d'un plasma. Une technique de gravure anisotrope assure un meilleur contrôle des dimensions des cavités 111.

Le procédé comprend ensuite la formation d'espaceurs contre les parois latérales 113 des cavités 111, afin de réduire la largeur W' des cavités au-delà de la limite de résolution de la photolithographie, jusqu'à une valeur inférieure à 12,5 nm. Ces espaceurs peuvent être réalisés en deux étapes successives S13 et S14, représentées respectivement par les figures 2C et 2D.

En référence à la figure 2C, une deuxième couche 120 en matériau sacrificiel est déposée de manière conforme sur le substrat 100 recouvert de la couche de neutralisation 220 et de la première couche 110. La deuxième couche 120 est ainsi d'épaisseur constante et épouse le relief formé à la surface du substrat 100. L'épaisseur de la deuxième couche 120 est de préférence comprise entre 5 nm et 25 nm. La technique de dépôt conforme employée pour déposer la deuxième couche 120 est par exemple le dépôt en couches atomiques (ou ALD, pour « Atomic Layer Déposition » en anglais), éventuellement assisté par plasma (PEALD, « Plasma Enhanced Atomic Layer Déposition »).

Le matériau sacrificiel de la deuxième couche 120 peut notamment être choisi parmi le dioxyde de silicium ($SiO_2$), un oxyniture de silicium ($SiO_xN_y$), l'alumine ($Al_2O_3$) et le dioxyde d'hafnium ($HfO_2$). Il n'est donc pas nécessairement identique au matériau sacrificiel de la première couche 110.

En référence à la figure 2D, la deuxième couche 120 est ensuite gravée de façon anisotrope, de préférence au moyen d'un plasma (par exemple fluorocarboné). La direction préférentielle de gravure est perpendiculaire à la surface du substrat 100. Cette étape de gravure anisotrope permet d'éliminer uniquement les parties horizontales de la deuxième couche 120, disposées au-dessus de la première couche 110 et au fond des cavités 111. Les parties verticales de la deuxième couche 120, disposées contre les parois latérales 113 des cavités 111, sont conservées et constituent des espaceurs 130.

La gravure de la deuxième couche 120 est sélective par rapport au substrat 100 et à la première couche 110. Le matériau du substrat est de préférence insensible à la gravure du matériau sacrificiel. Dans le cas contraire, une couche spécifique peut être prévue pour protéger le substrat 100 de la gravure.

Lors de ces étapes S13 et S14, la première couche 110 en matériau sacrificiel protège la couche de neutralisation 220. L'affinité chimique de la couche de neutralisation 220 ne risque donc pas d'être modifiée par le plasma de dépôt (PEALD) ou le plasma de gravure.

À l'étape S15 de la figure 2E, un deuxième polymère 150 ayant une affinité préférentielle pour l'un des blocs du copolymère est greffé sur le substrat 100 au fond des cavités 111, dans des régions situées entre les espaceurs 130. Pour ce faire, le deuxième polymère 150 peut être dissous dans un solvant pour former une deuxième solution de polymère, puis cette deuxième solution est déposée sur le substrat 100 jusqu'à remplir, partiellement ou entièrement, les cavités 111. La deuxième solution de polymère est de préférence déposée sur le substrat 100 par centrifugation. Le greffage est ensuite effectué, par exemple par recuit selon le même mode opération que celui décrit en relation avec la figure 2A. Une partie du deuxième polymère 150 en solution se fixe alors au substrat 100 au fond des cavités 111 et, de façon superflue, à la surface des espaceurs 130. Comme précédemment, le greffage est avantageusement suivi d'une opération de rinçage par solvant.

La première couche 110 et les espaceurs 130 en matériau sacrificiel agissent ainsi comme un masque ou pochoir pour localiser le greffage du deuxième polymère 150 sur le substrat 100.

Le deuxième polymère 150 est de préférence un homopolymère de même composition que l'un des blocs du copolymère, par exemple un homopolymère de polystyrène (h-PS). Par ailleurs, sa masse molaire est avantageusement inférieure à 5 kg.mol$^{-1}$, afin d'assurer une forte densité de greffage au niveau du substrat 100.

L'étape S16 de la figure 2F consiste ensuite à retirer la première couche 110 et les espaceurs 130 en matériau sacrificiel sélectivement par rapport au substrat 100, au premier polymère et au deuxième polymère 150 greffé sur le substrat. Le deuxième polymère 150 greffé à la surface des espaceurs 130 est éliminé en même temps que les espaceurs 130. Seuls subsistent alors sur le substrat 100, à l'issue de l'étape S16, la couche de neutralisation 220 et des motifs du deuxième polymère. Ces motifs ont la forme et les dimensions du fond 112 des cavités 111 après l'étape de formation des espaceurs 130 (cf. Figs.2C-2D ; réduction de la largeur W' des cavités 111). Ils constituent les motifs de guidage 210 de la structure de guidage chimique 200.

Les motifs de guidage 210 de la figure 2F présentent avantageusement un pas de répétition $L_s$ (« pitch » en anglais) sensiblement égal à un multiple entier de la période naturelle $L_0$ (Ls = n*L$_0$, avec $n$ un entier naturel non nul). Le pas de répétition $L_s$ correspond à la distance qui sépare le bord d'un motif de guidage 210 et le même bord du motif de guidage 210 suivant, par exemple les deux bords à gauche (ou qui sépare les centres de deux motifs de guidage 210 consécutifs). Le pas de répétition $L_s$ est ici égal à la période P des cavités 111 (cf. Fig.2B).

Dans ce premier mode de mise en œuvre, les motifs de guidage 210 sont séparés de la couche de neutralisation 220 par des régions nues de la surface du substrat 100. Dans ces régions, créées par le retrait des espaceurs 130, l'affinité chimique vis-à-vis du copolymère à blocs est définie par le substrat 100. Le substrat 100 peut être constitué d'un matériau ayant une affinité préférentielle pour l'un des blocs du copolymère, différente de celle des motifs de guidage 210, ou au contraire une affinité équivalente pour chacun des blocs du copolymère, comme la couche de neutralisation 220.

Le retrait de l'étape S16 peut être effectué par voie humide en une seule opération si le matériau sacrificiel de la première couche 110 et le matériau sacrificiel des espaceurs 130 sont identiques, ou a minima, sensibles à la même solution de gravure. La solution de gravure est par exemple une solution d'acide fluorhydrique (HF) lorsque la première couche 110 et les espaceurs 130 sont en $SiO_2$.

L'élimination de la première couche 110 et des espaceurs 130 peut aussi être effectuée en deux opérations successives. Les matériaux sacrificiels et les solutions de gravure sont alors nécessairement différents (par exemple HF pour $SiO_2$, $H_3PO_4$ pour Si3N4).

L'étape S16 de retrait de la première couche 110 et des espaceurs 130 est avantageusement suivie d'un rinçage au solvant (eau, PGMEA...), afin d'éliminer les résidus de gravure.

Dans une variante de mise en œuvre du procédé, non représentée sur les figures, la deuxième solution de polymère est déposée à l'étape S15 en surépaisseur sur la première couche 110. Le deuxième polymère 150 se greffe alors également sur la première couche 110 en matériau sacrificiel. Pour donner accès à la solution de gravure de la première couche 110 et des espaceurs 130, il peut être nécessaire de retirer préalablement le deuxième polymère 150 greffé sur la première couche 110. Ce retrait peut être effectué lors d'une étape dite de planarisation, au moyen d'un plasma (par exemple à base de CO, $O_2$, $CO_2$, $H_2$, $N_2$...), avec arrêt de la gravure sur la première couche 110 (par détection de la première couche 110 en réflectométrie).

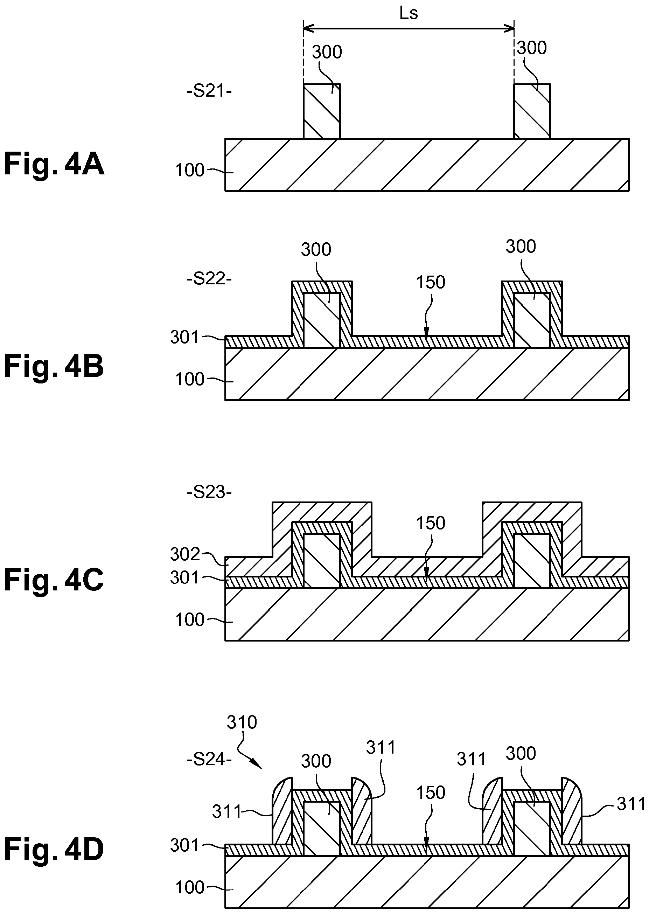

Les figures 4A à 4G représentent des étapes S21 à S27 du procédé de formation de structure de guidage chimique, d'après un deuxième mode de mise en œuvre de l'invention.

Dans ce deuxième mode de mise en œuvre, l'ordre dans lequel sont formés les motifs de guidage 210 et la couche de neutralisation 220 est inversé. La manière dont sont formés les motifs de guidage 210 en deuxième polymère diffère également par rapport au premier mode de mise en œuvre. Plutôt que de localiser le greffage du deuxième polymère 150 à l'aide d'un masque (cf. Fig.2E), le deuxième polymère peut être greffé ou réticulé sur une large zone du substrat, puis structuré au moyen d'un masque comprenant des espaceurs.

Les étapes S21 à S24 sont relatives à la formation des espaceurs.

Lors d'une première étape S21 illustrée par la figure 4A, des motifs 300 en forme de de mesa, appelés communément « mandrins », sont formés sur le substrat 100, par exemple par dépôt d'une couche en matériau sacrificiel et structuration de la couche par photolithographie. Le matériau sacrificiel des mandrins 300 est par exemple un matériau carboné déposé par centrifugation (« Spin On Carbon », SOC). Les mandrins 300 présentent avantageusement un pas de répétition $L_s$ sensiblement égal à un multiple entier de la période naturelle $L_0$ du copolymère à blocs (Ls = n*$L_0$ ± 10 %, avec *n* un entier naturel non nul), et de préférence compris entre 60 nm et 140 nm.

Puis, à l'étape S22 de la figure 4B, une couche 301 du deuxième polymère 150 est formée sur le substrat 100 et les mandrins 300. Le deuxième polymère 150 peut ici être un matériau greffable ou réticulable. La couche 301 du deuxième polymère 150 peut être formée de la façon décrite ci-dessus en relation avec la figure 2A et la couche de neutralisation 220 en premier polymère 140 : dépôt d'une solution par centrifugation, suivi du greffage/réticulation par recuit ou réticulation par UV, suivi du rinçage. La couche 301 du deuxième polymère 150 recouvre alors toute la surface libre du substrat 100 et des mandrins 300. Elle est de préférence d'épaisseur constante (2-15 nm).

En S23 (cf. Fig.4C), une couche 302 en matériau sacrificiel (ex. $SiO_2$, $SiO_xN_y$, $Al_2O_3$ $HfO_2$...) est déposée de manière conforme (ex. PLD, PEALD) sur la couche 301 du deuxième polymère 150. L'épaisseur de la couche 302 en matériau sacrificiel est constante et inférieure à 12,5 nm.

À l'étape suivante S24 (cf. Fig.4D), la couche 302 en matériau sacrificiel est gravée de manière sélective par rapport au deuxième polymère 150. Cette gravure est anisotrope, selon une direction perpendiculaire à la surface du substrat 100, de façon à éliminer les parties horizontales de la couche 302 en matériau sacrificiel et conserver uniquement ses parties verticales, disposées contre les flancs des mandrins 300. De préférence, une technique de gravure sèche est employée à l'étape S24, par exemple une gravure plasma à base de fluor ($F_2$).

Les parties verticales de la couche 302 en matériau sacrificiel constituent des espaceurs 311. Les espaceurs 311 sont donc des motifs en saillie regroupés par paire et disposés de part et d'autre des mandrins 300 (seules deux paires d'espaceurs sont représentées sur la figure 4D). La section et les dimensions des espaceurs 311, dans un plan parallèle au substrat 100, correspondent à celles des motifs de guidage 210 qu'on cherche à réaliser. L'ensemble des espaceurs 311 constitue un masque de gravure 310.

Le deuxième polymère 150 est de préférence un matériau réticulable ou un matériau greffable insensible au plasma utilisé le cas échéant pour déposer la couche 302 en matériau sacrificiel (PECVD) (Fig.4C) et/ou pour graver de façon anisotrope cette même couche 302 (Fig.4D). Ce matériau greffable peut notamment être l'homopolymère de polystyrène (h-PS). Les polymères réticulables comme le X-PS présentent l'avantage d'être plus résistants que les polymères greffables. Par contre, ils sont plus difficiles à mettre en œuvre, car il est plus difficile de réaliser par centrifugation un film uniforme de faible épaisseur (inférieure à 10 nm).

En référence à la figure 4E, le procédé comprend ensuite une étape S25 de gravure de la couche 301 du deuxième polymère à travers les espaceurs du masque 310, jusqu'à atteindre le substrat 100. La gravure, anisotrope, peut être effectuée au moyen d'un plasma, par exemple à base d'oxygène ($O_2$). Il résulte de cette étape S25 un transfert des motifs espaceurs 311 dans la couche 301 du deuxième polymère, autrement dit des motifs de guidage 210 en nombre identique au nombre de motifs espaceurs 311 dans le masque 310. Les mandrins 300 en matériau carboné sont avantageusement éliminés au cours de cette même étape S25. Le substrat 100 est de préférence insensible à la gravure (ou protégé par une couche insensible à la gravure).

La largeur W (mesurée dans le plan de coupe des figures 4A-4G) est la plus petite dimension des espaceurs 311, qu'on appelle communément « dimension critique ». Elle fixe la largeur des motifs de guidage 210 de la structure de guidage chimique 200 (cf. Fig.4E). La dimension critique W des espaceurs 311 - et donc des motifs de guidage 210 - est ici inférieure à 12,5 nm, afin de pouvoir assembler les copolymères à blocs de nouvelle génération appelés « high-X ».

Avantageusement, la dimension critique W des espaceurs 311 est en outre sensiblement égale à la moitié de la période naturelle $L_0$ du copolymère à blocs (W = $L_0$/2 ± 10 %), afin de minimiser le nombre de défauts d'organisation des blocs du copolymère. La distance D1 qui sépare deux espaceurs d'une même paire, autrement dit la largeur des mandrins 300 (cf.Figs.4D-4E), est sensiblement égale à un nombre impair de demi-périodes naturelles $L_0/2$ (D1 = n1 $*L_0/2 \pm 10$ %, avec *n1* un entier naturel impair), par exemple égale à $3*L_0/2$. La distance D2 qui sépare deux paires consécutives d'espaceurs 311 est sensiblement égale à un nombre impair de demi-périodes naturelles $L_0/2$ (D2 = n2$*L_0/2 \pm 10$ %, avec *n2* un entier naturel impair), par exemple égale à $3*L_0/2$. Le pas de répétition $L_s$ des mandrins 300 (cf. Fig.4A) ou des paires d'espaceurs (cf. Fig.4E) est donc bien égal à un multiple entier de la période naturelle $L_0$ du copolymère à blocs (Ls = D1 +D2+2W = n1$*L_0/2$+n2$*L_0/2$+2$*L_0/2$ = n$*L_0$, avec *n* un entier naturel non nul, n1 et n2 des entiers naturels impairs). La distance bord à bord (ou centre à centre) entre deux espaceurs 311 consécutifs est aussi égale à un multiple entier de la période naturelle $L_0$ du copolymère à blocs

$$(D1+W = (n1+1)*L_0/2 \text{ et } D2+W = (n2+1)*L_0/2).$$

L'étape S26 suivante, illustrée par la figure 4F, consiste à greffer le premier polymère 140 sur le substrat 100 afin de former la couche de neutralisation 220. Le premier polymère 140 est greffé à travers les espaceurs 311 dans une ou plusieurs régions dépourvues de motifs de guidage 210, et avantageusement sur toute la surface du substrat 100 en dehors des motifs de guidage 210. De préférence, l'étape S26 de la figure 4F se déroule de la façon décrite en relation avec la figure 2E (étape S15).

Enfin, à l'étape S27 de la figure 4G, les espaceurs 311 en matériau sacrificiel sont retirés sélectivement par rapport au substrat 100 et aux premier et deuxième polymères, de sorte à exposer les motifs de guidage 210. Le retrait des espaceurs 311 peut être effectué par gravure humide (par exemple HF dans le cas d'espaceurs en $SiO_2$).

Lorsque le deuxième polymère 150 est un matériau réticulable, le retrait des espaceurs 311 (étape S27) peut également avoir lieu avant le greffage du premier polymère 140 (étape S26). En effet, les motifs de guidage 210 formés du deuxième polymère ne sont dans ce cas pas affectés par le greffage du premier polymère (le premier polymère greffable ne vient pas remplacer ou se mélanger au deuxième polymère réticulable).

La structure de guidage chimique 200 obtenue à l'issue du procédé selon l'invention et représentée par les figures 2F et 4G peut être utilisée dans un procédé d'auto-assemblage dirigé de copolymère à blocs (« Directed Self-Assembly », DSA), et plus particulièrement dans un procédé de chémo-épitaxie, afin de générer des motifs secondaires de très hautes résolution et densité.

En référence aux figures 3 et 5, ce procédé de chémo-épitaxie comporte (outre la formation de la structure de guidage 200) une étape de dépôt d'un copolymère à blocs 500 sur la structure de guidage chimique 200 et une étape d'assemblage du copolymère à blocs 500, par exemple par recuit thermique. Le copolymère à blocs 500 peut être un copolymère di-blocs (deux monomères) ou multi-blocs (plus de deux monomères), un mélange de polymères, un mélange de copolymères ou encore le mélange d'un copolymère et d'un homopolymère. Les blocs du copolymère sont après assemblage orientés perpendiculairement au substrat 100, grâce à la présence de la couche de neutralisation 220.

Dans le mode de mise en œuvre de la figure 3 (correspondant aux figures 2A-2F), le copolymère à blocs 500 peut être de morphologie quelconque, par exemple lamellaire, cylindrique, sphérique, gyroïde..., selon la proportion entre les blocs de monomère.

Dans le mode de mise en œuvre de la figure 5 (correspondant aux figures 4A-4G), le copolymère à blocs 500 est de morphologie lamellaire, car les espaceurs 311 et les motifs de guidage 210 ont une section (dans un plan parallèle au substrat 100) en forme de ligne.

Le copolymère à blocs 500 est de préférence un copolymère « high-X », c'est-à-dire un copolymère de période naturelle $L_0$ inférieure à 25 nm. Il peut être choisi parmi les matériaux suivants :

- PS-*b*-PMMA : polystyrène-bloc-polyméthylméthacrylate, dont au moins un des deux blocs est modifié chimiquement ;
- PS-*b*-PDMS : polystyrène-bloc-polydiméthylsiloxane ;
- PS-*b*-PLA : polystyrène-bloc-acide polylactique ;
- PS-*b*-PEO : polystyrène-bloc-polyoxyde d'éthylène ;
- PS-*b*-PMMA-*b*-PEO : polystyrène-bloc-polyméthylméthacrylate-bloc-polyoxyde d'éthylène ;
- PS-*b*-P2VP : polystyrène-bloc-poly(2vinylpyridine) ;
- PS-*b*-P4VP : polystyrène-bloc-poly(4vinylpyridine) ;
- PS-*b*-PFS : poly(styrene)-block-poly(ferrocenyldimethylsilane) ;
- PS-*b*-PI-*b*-PFS : poly(styrene)-block-poly(isoprene)-block-poly(ferrocenyldimethylsilane) ;
- PS-*b*-P(DMS-r-VMS) : polystyrene-block-poly(dimethylsiloxane-r-vinylmethylsiloxane) ;
- PS-*b*-PMAPOSS : polystyrene-block-poly(methyl acrylate)POSS ;
- PDMSB-*b*-PS : poly(1,1-dimethylsilacyclobutane)-block-polystyrene ;
- PDMSB-*b*-PMMA : poly(1,1-dimethylsilacyclobutane)-block-poly(methyl methacrylate) ;

- PMMA-*b*-PMAPOSS : poly(methyl methacrylate)-block-poly(methyl acrylate)POSS ;
- P2VP-*b*-PDMS : poly(2-vinylpyridine)-block-poly(dimethyl siloxane) ;
- PTMSS-*b*-PLA : poly(trimethylsilylstyrene)-block-poly(D,L-lactide) ;
- PTMSS-*b*-PDLA : poly(trimethylsilylstyrene)-block-poly(D-lactic acid) ;
- PTMSS-*b*-PMOST : poly(trimethylsilylstyrene)-block-poly(4-methoxystyrene) ;
- PLA-*b*-PDMS : poly(D,L-lactide)-block-poly(dimethylsiloxane) ;
- PAcOSt-*b*-PSi2St : poly(4-acetoxystyrene)-block-poly(4-(Bis(trimethylsilyl)methyl)styrene) ;
- 1,2-PB-b-PDMS : 1,2-polybutadiene-block-poly(dimethyl siloxane) ;
- PtBS-*b*-PMMA : poly(4-tert-butylstyrene)-block-poly(methyl methacrylate) ;
- PCHE-*b*-PMMA : polycyclohexane-block-poly(methyl methacrylate) ;
- MH-*b*-PS : maltoheptaose-block-polystyrene.

Le document WO2014/165530, dont le contenu est incorporé ici par référence, donne des exemples de copolymère PS-*b*-PMMA ayant au moins un bloc modifié chimiquement. Le copolymère PS-*b*-PMMA modifié est par exemple le P(S-VBCB)-*b*-PMMA (poly(styrene-co-2-vinylbenzocyclobutene-block-poly(methyl methacrylate)). Le ratio molaire entre le styrène et le VBCB dans le premier bloc est typiquement compris entre 90/10 et 10/90, préférentiellement entre 90/10 et 30/70 et plus préférentiellement encore entre 50/50 et 30/70.

Le copolymère à blocs a typiquement une masse moléculaire moyenne comprise entre 1 000 Da et 100 000 Da, de préférence entre 5 000 Da et 50 000 Da et plus préférentiellement encore entre 10 000 Da et 40 000 Da. De plus, le ratio molaire entre le premier bloc et le deuxième bloc est typiquement compris entre 90/10 et 10/90, préférentiellement entre 70/30 et 30/70, et plus préférentiellement encore de 50/50 (pour avoir une morphologie lamellaire).

De façon plus générale, le copolymère PS-*b*-PMMA modifié (dont le bloc PS est modifié) peut être de formule P(S-X)-*b*-PMMA, où X peut être un des monomères suivants ou une combinaison des monomères suivants : vinyl benzocyclobutene (VBCB), 1-vinylnaphthalate, 2-vinylnapthalate, 2-vinylanthracene, 9-vinylanthracene, 9-vinylphenanthrene, 4-trimethylsilylstyrene.

La figure 6 représente une étape optionnelle S37 du procédé des figures 4A-4G. Celle-ci se déroule après l'étape S26 de la figure 4F.

Lors de cette étape S37, l'affinité chimique de la couche de neutralisation 220 est modifiée localement, c'est-à-dire dans une partie seulement de la couche de neutralisation 220, afin de former à la surface du substrat 100 une zone 400 d'affinité préférentielle avec l'un des blocs du copolymère. La zone 400 est de préférence dépourvue de motif de guidage 210.

L'affinité chimique de la couche de neutralisation 220 est de préférence modifiée par exposition à un rayonnement ultraviolet (UV) 410 de longueur d'onde $\lambda$ comprise entre 150 nm et 350 nm, par exemple égale à 172 nm.

Pour localiser la modification chimique de la couche de neutralisation 220, un masque (non représenté) peut être interposé entre la source du rayonnement et le substrat 100, qui supporte la couche de neutralisation 220. Le masque expose une première portion 220a de la couche de neutralisation, dont on souhaite modifier l'affinité chimique. Par contre, il recouvre les motifs de guidage 210 et une deuxième portion 220b de la couche de neutralisation, qu'on souhaite au contraire laisser intacts. L'exposition peut dans ce cas avoir lieu avant ou après l'étape S27 de retrait des espaceurs 311.

Comme illustrée par la figure 6, l'exposition au rayonnement UV 410 peut alternativement être effectuée sur toute la surface du substrat 100 (i.e. pleine plaque), sans interposer de masque, en tirant profit des espaceurs 311. L'exposition doit alors avoir lieu avant le retrait des espaceurs 311.

En effet, en les espaçant deux à deux d'une distance inférieure ou égale à la moitié de la longueur d'onde $\lambda$ du rayonnement UV (D1 $\leq \lambda/2$ et D2 $\leq \lambda/2$ ; cf. Fig.4E), les espaceurs 311 forment un filtre qui empêche le rayonnement UV 410 d'atteindre les motifs de guidage 210 et la deuxième portion 220b de la couche de neutralisation.

D'autres traitements, tels que l'exposition à un faisceau électronique, l'implantation ionique ou l'exposition à certains plasmas, peuvent être mis en œuvre (en association avec un masque) pour modifier localement l'affinité chimique de la couche de neutralisation 220.

La figure 7 représente une structure de guidage 200', obtenue après le retrait des espaceurs 311 de la figure 6, et l'assemblage du copolymère à blocs 500 sur cette structure de guidage 200'. La structure de guidage 200' comporte les motifs de guidage 210, la première portion 220a et la deuxième portion 220b de la couche de neutralisation.

Lors de l'assemblage, les blocs du copolymère ne s'orientent pas perpendiculairement au substrat 100 dans la zone 400 d'affinité préférentielle, où se situe la première portion 220a de la couche de neutralisation, mais parallèlement au substrat 100. Aucun transfert de motifs secondaires (après retrait d'une des phases du copolymère) ne pourra donc avoir lieu dans cette zone 400 du substrat.

Comme indiqué précédemment, l'utilisation des espaceurs 130 (Figs.2A-2F) et 311 (Figs.4A-4G) pour délimiter les motifs de guidage 210 rend possible l'obtention d'une structure de guidage compatible avec les copolymères à blocs « high-X ». La largeur des espaceurs, et donc la dimension critique des motifs de guidage, peut être contrôlée facilement en jouant sur l'épaisseur du dépôt conforme. L'utilisation d'espaceurs permet en outre de diminuer la rugosité de bord de ligne (ou LER, pour « Line Edge Roughness ») et la rugosité de largeur de ligne (ou LWR, pour « Line Width Roughness ») des motifs de guidage, ce qui conduit à un assemblage de meilleure qualité.

Naturellement, le procédé de formation selon l'invention n'est pas limité aux modes de mise en œuvre décrits en référence aux figures 2, 4 et 6 et de nombreuses variantes et modifications apparaîtront à l'homme du métier. En particulier, le premier polymère 140 et le deuxième polymère 150 pourraient présenter d'autres compositions que celles décrites précédemment. De même, d'autres copolymères à blocs pourraient être utilisés.

Les structures de guidage chimique réalisables grâce au procédé de formation selon l'invention ne sont pas limitées à la juxtaposition de motifs de guidage en homopolymère et d'une couche de neutralisation. D'autres types de motifs, ayant des affinités chimiques différentes que celles décrites ci-dessus, peuvent être utilisés. Par exemple, la structure de guidage chimique 200 peut être composée d'un premier motif (ou ensemble de motifs) ayant une affinité préférentielle pour un bloc du copolymère et d'un deuxième motif (ou ensemble de motifs) ayant une affinité préférentielle pour un autre bloc du copolymère. Les premier et deuxième polymères pourraient être alors tous les deux des homopolymères.

## Revendications

1. Procédé de formation d'une structure de guidage chimique (200, 200') destinée à l'auto-assemblage d'un copolymère à blocs (500) par chémo-épitaxie, le procédé comprenant les étapes suivantes :

   - former sur un substrat (100) une couche de fonctionnalisation (220) en un premier matériau polymère (140) ayant une première affinité chimique vis-à-vis du copolymère à blocs (500) ;
   - former sur le substrat des motifs de guidage (210) en un deuxième matériau polymère (150) ayant une deuxième affinité chimique vis-à-vis du copolymère à blocs, différente de la première affinité chimique ;

   **caractérisé en ce que** les motifs de guidage (210) ont une dimension critique (W) inférieure à 12,5 nm et sont formés au moyen d'un masque (310) comprenant des espaceurs (130, 311).

2. Procédé selon la revendication 1, dans lequel la première affinité chimique est équivalente pour chacun des blocs du copolymère et dans lequel la deuxième affinité chimique est préférentielle pour l'un des blocs du copolymère.

3. Procédé selon l'une des revendications 1 et 2, comprenant les étapes suivantes :

   - former (S11) la couche de fonctionnalisation (220) sur le substrat (100) ;
   - déposer (S12) une couche de matériau sacrificiel (110) sur la couche de fonctionnalisation ;
   - former (S12) dans la couche de matériau sacrificiel (110) et dans la couche de fonctionnalisation (220) des cavités (111) débouchant sur le substrat (100), chaque cavité comprenant un fond (112) et des parois latérales (113) ;
   - former (S13, S14) les espaceurs (130) contre les parois latérales des cavités (111) ;
   - greffer (S15) le deuxième matériau polymère (150) au fond des cavités entre les espaceurs (130) ; et
   - retirer (S16) les espaceurs (130) et la couche de matériau sacrificiel (110).

4. Procédé selon l'une des revendications 1 et 2, comprenant les étapes suivantes :

   - former (S22) une couche (301) du deuxième matériau polymère (150) sur le substrat (100) ;
   - former (S23-S24) les espaceurs (311) sur la couche du deuxième matériau polymère ;
   - graver (S25) la couche (301) du deuxième matériau polymère à travers les espaceurs (311) pour former les motifs de guidage (210) ;
   - greffer (S26) le premier matériau polymère (140) sur le substrat en dehors des motifs de guidage pour former la couche de fonctionnalisation (220) ; et
   - retirer (S27) les espaceurs (311).

5. Procédé selon la revendication 4, comprenant en outre une étape (S37) de modification de la première affinité chimique dans une partie (220a) seulement de la couche de fonctionnalisation (220) par exposition à un rayonnement ultraviolet (410).

6. Procédé selon la revendication 5, dans lequel :

- l'exposition au rayonnement ultraviolet (410) est effectuée sur toute la surface du substrat (100) avant l'étape (S27) de retrait des espaceurs (311) ;
- le rayonnement ultraviolet présente une longueur d'onde (À) comprise entre 150 nm et 350 nm ; et
- les espaceurs (311) sont séparés deux à deux d'une distance (D1, D2) inférieure ou égale à la moitié de la longueur d'onde.

7. Procédé selon l'une quelconque des revendications 1 à 6, dans lequel la dimension critique (W) des motifs de guidage (210) est en outre sensiblement égale à la moitié de la période naturelle ($L_0$) du copolymère à blocs (500).

8. Procédé de chémo-épitaxie comprenant les étapes suivantes :

- former une structure de guidage chimique (200, 200') sur un substrat (100) à l'aide d'un procédé selon l'une quelconque des revendications 1 à 7 ;
- déposer un copolymère à blocs (500) sur la structure de guidage chimique (200, 200') ; et
- assembler le copolymère à blocs (500).

9. Procédé selon la revendication 8, dans lequel le copolymère à blocs (500) est un copolymère de période naturelle ($L_0$) inférieure à 25 nm.

**Patentansprüche**

1. Bildungsverfahren einer chemischen Führungsstruktur (200, 200'), die zur Assemblierung eines Block-Kopolymers (500) per Chemo-Epitaxie bestimmt ist, wobei das Verfahren die folgenden Schritte umfasst:

- Bilden einer Funktionalisierungsschicht (220) aus einem ersten Polymermaterial (140) mit einer ersten chemischen Affinität für das Block-Kopolymer (500) auf einem Substrat (100),
- Bilden von Führungsmustern (210) aus einem zweiten Polymermaterial (150) mit einer zweiten chemischen Affinität für das Block-Kopolymer, die von der ersten chemischen Affinität unterschiedlich ist, auf dem Substrat,

dadurch gekennzeichnet, dass die Führungsmuster (210) eine kritische Abmessung (W) von weniger als 12,5 nm aufweisen und mittels einer Maske (310) gebildet sind, die Abstandshalter (130, 311) umfassen.

2. Verfahren gemäß Anspruch 1, bei dem die erste chemische Affinität für jeden Block des Kopolymers äquivalent ist und bei dem die zweite chemische Affinität für einen der Blöcke des Kopolymers bevorzugt ist.

3. Verfahren gemäß einem der Ansprüche 1 und 2, umfassend die folgenden Schritte:

- Bilden (S11) der Funktionalisierungsschicht (220) auf dem Substrat (100);
- Aufbringen (S12) einer Schicht aus Opfermaterial (110) auf die Funktionalisierungsschicht;
- Bilden (S12) von auf das Substrat (100) mündenden Ausnehmungen (111) in der Schicht aus Opfermaterial (110) und in der Funktionalisierungsschicht (220), wobei jede Ausnehmung einen Boden (112) und Seitenwände (113) umfasst;
- Bilden (S13, S14) der Abstandshalter (130) gegen die Seitenwände der Ausnehmungen (111);
- Aufpfropfen (S15) des zweiten Polymermaterials (150) auf den Boden der Ausnehmungen zwischen den Abstandshaltern (130); und
- Abnehmen (S16) der Abstandshalter (130) und der Schicht aus Opfermaterial (110).

4. Verfahren gemäß irgendeinem der Ansprüche 1 und 2, umfassend die folgenden Schritte:

- Bilden (S22) einer Schicht (301) des zweiten Polymermaterials (150) auf dem Substrat (100);
- Bilden (S23-S24) der Abstandshalter (311) auf der Schicht des zweiten Polymermaterials;
- Ätzen (S25) der Schicht (301) des zweiten Polymermaterials durch die Abstandshalter (311), um die Führungsmuster (210) zu bilden;
- Aufpfropfen (S26) des ersten Polymermaterials (140) auf dem Substrat außerhalb der Führungsmuster zum Bilden der Funktionalisierungsschicht (220); und
- Abnehmen (S27) der Abstandshalter (311).

**5.** Verfahren gemäß Anspruch 4, umfassend darüber hinaus einen Abänderungsschritt (S37) der ersten chemischen Affinität nur in einem Teil (220a) der Funktionalisierungsschicht (220) per Aussetzen einer Ultraviolett-Strahlung (410).

**6.** Verfahren gemäß Anspruch 5, bei dem:

- das Aussetzen der Ultraviolett-Strahlung (410) auf der gesamten Oberfläche des Substrats (100) vor dem Abnahmeschritt (S27) der Abstandshalter (311) durchgeführt wird;
- die Ultraviolett-Strahlung eine Wellenlänge ($\lambda$) aufweist, die zwischen 150 nm und 350 nm inbegriffen ist; und
- die Abstandshalter (311) zu zweit in einer Entfernung (D1, D2) getrennt sind, die kleiner als oder gleich der Hälfte der Wellenlänge ist.

**7.** Verfahren gemäß irgendeinem der Ansprüche 1 bis 6, bei dem die kritische Abmessung (W) der Führungsmuster (210) darüber hinaus deutlich gleich der Hälfte der natürlichen Periode ($L_0$) des Block-Kopolymers (500) ist.

**8.** Chemo-Epitaxieverfahren, umfassend die folgenden Schritte:

- Bilden einer chemischen Führungsstruktur (200, 200') auf einem Substrat (100) mithilfe eines Verfahrens gemäß irgendeinem der Ansprüche 1 bis 7;
- Aufbringen eines Block-Kopolymers (500) auf die chemische Führungsstruktur (200, 200'); und
- Assemblieren des Block-Kopolymers (500):

**9.** Verfahren gemäß Anspruch 8, bei dem das Block-Kopolymer (500) ein Kopolymer mit einer natürlichen Periode ($L_0$) von weniger als 25 nm ist.

**Claims**

**1.** Method for forming a chemical guiding structure (200, 200') intended for self-assembly of a block copolymer (500) by chemoepitaxy, the method comprising the following steps:

- forming on a substrate (100) a functionalisation layer (220) made of a first polymer material (140) having a first chemical affinity with respect to the block copolymer (500);
- forming on the substrate guiding patterns (210) made of a second polymer material (150) having a second chemical affinity with respect to the block copolymer, different from the first chemical affinity;

**characterised in that** the guiding patterns (210) have a critical dimension (W) of less than 12.5 nm and are formed by means of a mask (310) comprising spacers (130, 311).

**2.** Method according to claim 1, wherein the first chemical affinity is equivalent for each of the copolymer blocks, and wherein the second chemical affinity is preferential for one of the blocks of the copolymer.

**3.** Method according to one of claims 1 and 2, comprising the following steps:

- forming (S11) the functionalisation layer (220) on the substrate (100);
- depositing (S12) a layer of sacrificial material (110) on the functionalisation layer;
- forming (S12) in the layer of the sacrificial material (110) and in the functionalisation layer (220) cavities (111) opening on to the substrate (100), each cavity comprising a bottom (112) and side walls (113);
- forming (S13, S14) the spacers (130) against the side walls of the cavities (111) ;
- grafting (S15) the second polymer material (150) on to the bottoms of the cavities between the spacers (130); and
- removing (S16) the spacers (130) and the layer of sacrificial material (110).

**4.** Method according to one of claims 1 and 2, comprising the following steps:

- forming (S22) a layer (301) of the second polymer material (150) on the substrate (100);
- forming (S23-S24) the spacers (311) on the layer of the second polymer material;
- etching (S25) the layer (301) of the second polymer material through the spacers (311) to form the guiding patterns (210);

- grafting (S26) the first polymer material (140) on to the substrate outside the guiding patterns to form the functionalisation layer (220); and
- removing (S27) the spacers (311).

5. Method according to claim 4, further comprising a step (S37) of modification of the first chemical affinity in a portion (220a) only of functionalisation layer (220) by exposure to ultraviolet radiation (410).

6. Method according to claim 5, wherein:

    - the exposure to ultraviolet radiation (410) is performed over the entire surface of the substrate (100) before step (S27) of removing the spacers (311);
    - the ultraviolet radiation has a wavelength ($\lambda$) comprised between 150 nm and 350 nm; and
    - the spacers (311) are separated two-by-two by a distance (D1, D2) less than or equal to half the wavelength.

7. Method according to any of claims 1 to 6, wherein the critical dimension (W) of the guiding patterns (210) is further substantially equal to half the natural period ($L_0$) of the block copolymer (500).

8. Chemoepitaxy method comprising the following steps:

    - forming a chemical guiding structure (200, 200') on a substrate (100) using a method according to any of claims 1 to 7;
    - depositing a block copolymer (500) on the chemical guiding structure (200, 200'); and
    - assembling the block copolymer (500).

9. Method according to claim 8, wherein the block copolymer (500) is a copolymer of natural period ($L_0$) of less than 25 nm.

(Art antérieur)

# Fig. 1

-S11-

## Fig. 2A

-S12-

## Fig. 2B

Fig. 2C

Fig. 2D

Fig. 2E

Fig. 2F

Fig. 3

**Fig. 4A**

-S21-

Ls

300                    300

100

**Fig. 4B**

-S22-

300                    300

150

301

100

**Fig. 4C**

-S23-

302
301

150

100

**Fig. 4D**

310

-S24-

311    300    311        311    300

150

311

301                                      311

100

**Fig. 4E**

**Fig. 4F**

**Fig. 4G**

500

200

100

210      220      210

**Fig. 5**

-S37-

200

220

100

410

311

311

400

210      220b      210      220a

**Fig. 6**

500

400

200'

100

210      220b      210      220a

**Fig. 7**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2017069486 A

- WO 2014165530 A

**Littérature non-brevet citée dans la description**

- **C-C. LIU et al.** Intégration of block copolymer directed assembly with 193 immersion lithography. *J. Vac. Sci. Technol.,* 2010, vol. B 28, C6B30-C6B34